# EUROPÄISCHE PATENTSCHRIFT

(11) **EP 3 661 131 B1**
(45) Veröffentlichungstag und Bekanntmachung des Hinweises auf die Patenterteilung: **07.09.2022**
(21) Anmeldenummer: 19218441.4
(22) Anmeldetag: 06.06.2018
(51) Int. Cl.: H04L 12/413, H04L 12/40, G06F 13/376, G06F 13/42

(54) **VERFAHREN ZUR ÜBERTRAGUNG VON DATEN ÜBER EINEN SERIELLEN KOMMUNIKATIONSBUS, ENTSPRECHEND AUSGELEGTE BUSSCHNITTSTELLE SOWIE ENTSPRECHEND AUSGELEGTES COMPUTERPROGRAMM**
METHOD FOR TRANSMITTING DATA VIA A SERIAL COMMUNICATION BUS, BUS INTERFACE DESIGNED FOR THIS PURPOSE, AND CORRESPONDINGLY DESIGNED COMPUTER PROGRAM
PROCÉDÉ DE TRANSMISSION DES DONNÉES PAR L'INTERMÉDIAIRE D'UN BUS DE COMMUNICATION SÉRIE, INTERFACE DE BUS CONÇUE DE MANIÈRE CORRESPONDANTE AINSI QUE PROGRAMME INFORMATIQUE CONÇU DE MANIÈRE CORRESPONDANTE

(30) Priorität: 11.07.2017 DE 102017211860
(43) Veröffentlichungstag der Anmeldung: 03.06.2020
(62) Teilanmeldung aus: 18176209.7
(73) Patentinhaber: Volkswagen Aktiengesellschaft, 38440 Wolfsburg (DE)
(72) Erfinder: Meier, Alexander, 38442 Wolfsburg (DE)

(56) Entgegenhaltungen:
- WO-A1-2015/139892
- DE-A1-102011 122 843
- US-A1- 2016 094 312
- "ROAD VEHICLES - CONTROLLER AREA NETWORK (CAN) - PART 1: DATA LINK LAYER AND PHYSICAL SIGNALLING", INTERNATIONAL STANDARD ISO 1, XX, XX, 1. Dezember 2003 (2003-12-01), XP008087403,

## Beschreibung

Die Erfindung betrifft das technische Gebiet der seriellen Datenübertragung zwischen elektronischen Komponenten insbesondere Steuergeräten, Sensoren und Aktoren, die über ein Bussystem vernetzt sind. Solche Steuergeräte werden vielfach in Kraftfahrzeugen eingesetzt. Vernetzte Steuergeräte, Sensoren und Aktoren werden auch in anderen Gebieten der Technik eingesetzt, z.B. in der Automatisierungstechnik, Prozesstechnik, usw. Die Erfindung betrifft ebenso eine entsprechend ausgelegte Busschnittstelle sowie ein entsprechend ausgelegtes Computerprogramm.

In modernen Fahrzeugen werden eine Vielzahl von Steuergeräten verbaut. Alleine für den Antriebstrang werden eine Anzahl Steuergeräte eingesetzt, so z.B. Motor-Steuergerät, Getriebe-Steuergerät, ESP-Steuergerät, Fahrwerk-Steuergerät und weitere. Daneben gibt es auch noch weitere Steuergeräte, die im Bereich der Fahrzeugkarosserie verbaut werden und für bestimmte Komfortfunktionen sorgen. Als Beispiele werden genannt die Tür- oder Fensterheber-Steuergeräte, Klimaanlage-Steuergeräte, Sitzverstellungs-Steuergeräte, Airbag-Steuergeräte u.a. Dann gibt es weiterhin Steuergeräte, die zu dem Infotainment-Bereich zählen, wie Kamera-Steuergerät zur Umfeldbeobachtung, Navigationsgerät, RADAR- oder LIDAR-Gerät, Kommunikationsmodul und Entertainmentmodul mit TV, Radio, Video und Musik-Funktion. Insbesondere für den Infotainment-Bereich der fahrzeuginternen Vernetzung von Steuergeräten soll zukünftig IP Kommunikation in Form von IPv6 oder IPv4 zum Einsatz kommen. Dabei werden IP-Pakete übertragen, die eine Länge von bis zu 64 kByte aufweisen können. Zwar können die IP-Pakete segmentiert übertragen werden, jedoch erfordert der Einsatz von IP Kommunikation, dass eine Bustechnologie verwendet wird, die hinreichend große Botschaften übertragen kann. Dabei wird gefordert, dass als MTU (Maximum Transmission Unit), wie sie von Ethernet bekannt sind, mindestens 1280 Byte große Pakete übertragen werden können. Jedoch erfüllen weder der im Kraftfahrzeug eingesetzte klassische CAN Bus 2.0, entsprechend Controller Area Network noch der bereits erweiterte CAN FD Bus, entsprechend Controller Area Network Flexible Data Rate diese Anforderung, da sie Botschaften mit einer maximalen Größe von nur 8 respektive 64 Byte übertragen können. Das macht den Einsatz des CAN-Busses ungeeignet, wenn er die geforderte IPv6 Kommunikation unterstützen soll. Hinsichtlich weiterer Einzelheiten zum IPv6-Protokoll wird auf die Spezifikation RFC 2460 der Internet Engineering Task Force IETF verwiesen.

Typischerweise werden die Steuergeräte der verschiedenen Kategorien jeweils mit einem separaten, für die Gerätekategorie entsprechend ausgelegten Bus vernetzt. Es können daher mehrere verschiedene Bussysteme im Fahrzeug eingesetzt werden. Die verschiedenen Bussysteme können dabei über Gateways miteinander verbunden sein, um einen Datenaustausch zu ermöglichen. Im Bereich der Antriebstrang-Steuergeräte wird typischerweise der CAN-Bus eingesetzt, ebenfalls im Bereich der Komfort-Steuergeräte. Im Infotainment-Bereich kommen auch andere Bussysteme zum Einsatz, wie Bussysteme die auf Ethernet-Technologie beruhen, z.B. AVB (Audio Video Bridging) der auf der Standard-Familie nach IEEE 802.1 Standard basiert. Auch Bussysteme, bei denen die Datenübertragung über Lichtwellenleiter geschieht, sind einsetzbar. Als Beispiele werden genannt der MOST Bus (Media Oriented System Transport) oder der D2B Bus (Domestic Digital Bus).

Es gibt die Möglichkeit über CAN 2.0 oder CAN FD ein Transportprotokoll wie ISO TP als Zwischenschicht zu verwenden, um IPv6 Pakete zu übertragen. Dies hat jedoch einige Nachteile.

Die Verwendung des Transportprotokolls ISO TP für die Übertragung von IP-Paketen hat den wesentlichen Nachteil, dass sich dadurch die Notwendigkeit der Segmentierung ergibt. Dies erhöht die Fehleranfälligkeit und verursacht einen Overhead bei der Übertragung der Daten. Dieser Overhead wird zum einen durch das Transportprotokoll selbst verursacht. Zum anderen wird ein Großteil des Overheads durch das CAN FD Protokoll selbst verursacht. Jeder CAN FD Übertragungsrahmen besteht aus einer Arbitrierungsphase, in der Bits mit langsamer Datenrate übertragen werden und einer Datenphase, in der die angegebene schnelle Datenrate tatsächlich genutzt werden kann. Dementsprechend kann die hohe Datenrate der Datenphase umso weniger genutzt werden, je häufiger die Arbitrierungsphase auftritt. Dieser Nachteil ist umso schwerwiegender, da die erreichbaren Datenraten bei der CAN Bus Technologie wegen des besonderen Buszugriffsverfahrens ohnehin begrenzt sind.

Ein weiterer wesentlicher Nachteil der Verwendung von ISO TP ist, dass gemäß ISO TP zustandsbehaftete Punkt-zu-Punkt Verbindungen verwendet werden, um Daten zu übertragen. Dies verbietet den Einsatz der Multicast-Funktionalitäten des IPv6-Standards. Auf der anderen Seite verliert man die positive Eigenschaft, dass IPv6 Pakete zustandslos sind und unabhängig von anderen IPv6 Paketen übertragen werden können. Bei der Verwendung von ISO TP hängt die Übertragung eines IPv6 Paketes davon ab, ob das vorhergehende Paket erfolgreich übertragen wurde.

Ein weiterer Nachteil bei der Verwendung von ISO TP zur Ermöglichung von IPv6 Kommunikation über CAN FD ist, dass sich durch das Prinzip mit zustandsbehafteten Punkt-zu-Punkt Verbindungen sehr lange Latenzzeiten bei der Übertragung von Daten ergeben. Das ist für Echtzeit-Anwendungen, bei denen es auf kurze Reaktionszeiten ankommt, ungeeignet. Bisher wird im Kfz-Bereich kaum IPv6 Kommunikation eingesetzt, da dies einen hohen Ressourcenaufwand bedeutet. Der übliche Ansatz IPv6 Kommunikation zu ermöglichen besteht darin als Vernetzungstechnologie die für den Kfz-Bereich teure Ethernet-Technologie einzusetzen.

Aus der ISO-Norm ISO 11898-1 2015-12-00 "Road vehicles - Controller area network (CAN) - Part 1: Data link layer and physical signalling" ist ein Übertragungsrahmen mit einem Arbitrierungsfeld und einem Datenfeld bekannt, bei dem für die Arbitrierungsphase eine niedrige Bitrate eingestellt wird und für die Übertragung der Daten im Datenfeld eine erhöhte Bitrate eingestellt wird. Die Anzahl der Datenbytes ist für klassische Übertragungsrahmen mit maximal 8 Bytes festgelegt. Dazwischen sind alle Werte erlaubt. Für FD Übertragungsrahmen sind maximal 64 Bytes im Datenfeld erlaubt. Hier sind auch Werte von 12, 16, 20, 24, 32, oder 48 Datenbytes möglich.

Aus der DE 10 2011 006 884 A1 ist ein Verfahren und eine Vorrichtung zur Erhöhung der Datenübertragungskapazität in einem seriellen Bussystem bekannt. Auch dieses Dokument zeigt die Verwednung von einem Übertragungsrahmen mit einem Arbitrierungsfeld und einem Datenfeld, bei dem für die Arbitrierungsphase eine niedrige Bitrate eingestellt wird und für die Übertragung der Daten im Datenfeld eine erhöhte Bitrate eingestellt wird.

Aus der DE 10 2011 122 843 A1 ist ein Verfahren und eine Vorrichtung zur seriellen Datenübertragung mit flexibler Nachrichtengröße und variabler Bitlänge bekannt.

Aus der DE 11 2015 004 473 T5 ist ein Hochgeschwindigkeits-Datenübertragungsprotokoll für Steuerungszwecke bekannt.

Aus der WO 2015 139 892 A1 ist ein Vorschlag für ein erweitertes CAN-Bus Übertragungsformat bekannt, bei dem auch eine UDS-Diagnose-Anforderung ohne Segmentierung in einem erweiterten Datenrahmen mit 4096 Bytes Länge übertragen werden kann.

Aus der US 2016 094 312 A1 ist ein Vorschlag für die Erweiterung des klassischen CAN-Bus Übertragungsformats bekannt, bei dem die Erweiterung die Ausdehnung des Datenfeldes auf 64 Byte Länge betrifft.

Die Erfindung setzt sich zum Ziel die beschriebenen Nachteile bei der Einführung von IP-Kommunikation im Kfz-Bereich zu vermeiden.

Diese Aufgabe wird durch ein Verfahren zur Übertragung von Daten über einen seriellen Kommunikationsbus, eine entsprechend ausgelegte Busschnittstelle sowie ein entsprechend ausgelegtes Computerprogramm gelöst.

Die abhängigen Ansprüche beinhalten vorteilhafte Weiterbildungen und Verbesserungen der Erfindung entsprechend der nachfolgenden Beschreibung dieser Maßnahmen.

Für die Lösung der Aufgabe wird der Ansatz verfolgt das im Kfz-Bereich dominierende CAN Protokoll selbst inkompatibel weiterzuentwickeln um es für die IP Kommunikation tauglich zu machen. Dabei wird im Folgenden das hier neu vorgeschlagene erweiterte CAN Protokoll kurz als CAN EL Protokoll bezeichnet.

Die erste Maßnahme mit der das bestehenden CAN FD Protokoll weiterentwickelt wird, besteht darin bei einem Verfahren zur Übertragung von Daten über einen seriellen Kommunikationsbus, bei dem die Daten mit einem Übertragungsrahmen übertragen werden, wobei der Übertragungsrahmen wenigstens ein Arbitrierungs-Feld und ein Daten-Feld aufweist, dass die Länge des Datenfeldes im Übertragungsrahmen drastisch erweitert wird. Dabei dient das Arbitrierungs-Feld zur Regelung des Buszugriffs nach dem CSMA-CR Verfahren, entsprechend Carrier Sense Multiple Access with Collision Resolution durch Priorisierung der Botschaften mit Hilfe eines Identifizierers. Wie beim CAN FD Bus wird für die Arbitrierungsphase eine niedrige Bitrate eingestellt und für die Übertragung der Daten im Datenfeld eine erhöhte Bitrate eingestellt. Durch die Verlängerung des Nutzdaten-Feldes wird der Nachteil, dass bei dem CAN FD Bus wegen der dort festgelegten Beschränkung der Länge des Nutzdaten-Feldes auf maximal 64 Byte der Vorteil der höheren Bitrate kaum ausgenutzt wird, bei dem hier vorgeschlagenen erweiterten CAN EL Bus vermieden. Die Maßnahme bietet den Vorteil einer deutlich gesteigerten Datenrate/Bandbreite bei der Datenübertragung. Dies bedeutet auch eine signifikant verbesserte Effizienz bei der Übertragung großer Datenpakete. Gleichzeitig wird die bei dem CAN FD Bus vorhandene Beschränkung, dass innerhalb des Nutzdatenfeldes mit maximaler Größe von 64 Bytes nur bestimmte Anzahlen von Bytes möglich sind, aufgehoben. Die Nutzungsmöglichkeiten sind dadurch noch flexibler.

Zusätzlich wird im Übertragungsrahmen ein Ende-Feld vorgesehen und in das Ende-Feld wenigstens ein End-of-Frame-Code eingetragen, wobei der End-of-Frame-Code eine Länge von 11 Bit aufweist.

Diese Maßnahme ist bei einer veränderten Bitstuffing Regel von Vorteil. Durch Senden des End-of-Frame Codes wird eine Verletzung einer neuen Bitstuffing-Regel erzwungen, so dass Teilnehmer, die nicht korrekt synchronisiert waren, diese Tatsache erkennen und den CAN-Controller zurücksetzen können um wieder korrekt synchronisiert zu werden.

Die Variabilität der Länge des Nutzdatenfeldes garantiert viele Einsatzmöglichkeiten. So braucht kein Kompromiss eingegangen zu werden, wenn es je nach Anwendungsfall auf eine hohe Nettodatenrate ankommt oder in einem anderen Fall mehr die Echtzeitfähigkeit im Vordergrund steht und es mehr auf geringe Latenzzeiten ankommt.

Dabei ist es besonders vorteilhaft, wenn für die variable Länge des Daten-Feldes ein Bereich von 0 bis 4096 Bytes spezifiziert wird. Dies ermöglicht eine gute Interoperabilität mit der heute vielfach zur Anwendung kommenden 1 GBit-Ethernet Variante. Ein Routing zwischen einem Teil des Kfz-Netzwerks wo die 1 GBit Ethernet Bus Variante zum Einsatz kommt, wäre dann ohne Segmentierung möglich. Der Einsatz von IP Kommunikation wird dadurch problemlos möglich.

Es ist ebenfalls von Vorteil, wenn die Länge des auf 32 Bit festgelegt wird. Bei dem CAN FD Standard wurde eine Länge von 29 Bit für dieses Feld festgelegt. Diese Maßnahme vereinfacht die Hardwareentwicklung für den erweiterten CAN EL Bus. Die heute üblichen Registerlängen sind typischerweise ein Vielfaches von einem Byte, d.h. ein Vielfaches von 8 Bit.

Weiterhin vorteilhaft ist, wenn wie beim CAN FD Protokoll im Übertragungsrahmen ein Steuerungs-Feld zwischen Arbitrierungs-Feld und Daten-Feld vorgesehen wird, in dem wenigstens ein Abschnitt für die Längenangabe bzgl. des Daten-Feldes vorgesehen wird. Hier ist also eine Verlängerung dieses Abschnitts erforderlich um die volle Länge von 4096 Bytes angeben zu können. Dafür sind 13 Bits nötig.

Wie beim CAN 2.0 Protokoll und CAN FD Protokoll ist es vorteilhaft, wenn im Übertragungsrahmen ein CRC-Feld vorgesehen wird, in dem wenigstens ein Abschnitt für einen CRC-Prüfcode vorgesehen wird. Der CRC Prüfcode dient zur Fehlerdetektion entsprechend des bekannten Cyclic Redundancy Check Algorithmus.

Dabei ist es wie beim CAN FD Protokoll von Vorteil, wenn im Übertragungsrahmen ein Start-Feld vorgesehen wird und der CRC-Prüfcode über die Felder Start-Feld, Arbitrierungs-Feld, Steuerungs-Feld und Daten-Feld berechnet wird.

Das Gleiche gilt für den Einsatz des Bit-Stuffing Verfahrens, das ebenfalls schon beim CAN 2.0 Protokoll und CAN FD Protokoll zum Einsatz kam. Hier ist es vorteilhaft, dass die Übertragung der Daten asynchron erfolgt und zur Gewährleistung des Gleichtaktes von Datensende-Station und Datenempfangs-Station eine Resynchronisation nach einer Bitstuffing-Regel durchgeführt wird, wobei die Bitstuffing-Regel über die Bereiche vom Start-Feld bis zum Ende des Daten-Feldes angewendet wird, wobei die Anzahl der eingefügten Stuff-Bits zur Kontrolle in einem Abschnitt des CRC-Feldes eingetragen wird. Durch die Einfügung eines Stuff-Bits wird ein Flankenwechsel auf dem Bus erzwungen, welcher im CAN-Controller zur Resynchronisation des Taktgebers dient, der den Abtasttakt für die Bitrückgewinnung beim Empfang von Daten vorgibt. Dabei wir eine modifizierte Bitstuffing-Regel eingesetzt. Der Bitstuffing Algorithmus (Frame Encoding) wird für das neue Übertragungsformat insofern abgewandelt, dass ein Stuffbit nicht wie bei CAN 2.0 und CAN FD nach 5 sondern erst nach 10 unmittelbar aufeinander folgenden Bits mit dem gleichen Bus-Pegel eingefügt wird. Es werden dadurch weniger "Overhead"-Bits im Datenrahmen benötigt und es wird dadurch die Effizienz der Datenübertragung gesteigert.

Im CRC-Feld wird die Bitstuffing Regel nach dem erweiterten Protokoll nicht eingesetzt. Deshalb ist es zusätzlich von Vorteil, wenn im CRC-Feld an fest vorgegebenen Positionen ein Stuff-Bit zwangsweise eingefügt wird. So werden auch im CRC-Feld Flankenwechsel garantiert und die CAN-Controller der Busteilnehmer bleiben synchronisiert.

In einem bevorzugten Beispiel beginnt das CRC-Feld mit einem fest vorgegebenen Stuff-Bit und die weiteren fest vorgegebenen Stuff-Bits werden im Abstand von jeweils 9 Bits des CRC-Feldes eingefügt. Das fest vorgegebene Stuff-Bit ist dabei komplementär zu seinem Vorgänger-Bit.

Eine besonders vorteilhafte Maßnahme betrifft die Vergabe der Identifizierer im Arbitirierungs-Feld für die Priorisierung der Botschaften. Demnach wird der Identifizierer im Arbitrierungs-Feld in die Bereiche "Botschafts-Inhalt"-Identifizierer und "Geräte"-Identifizierer unterteilt. Durch die entsprechende Vergabe der Geräte ID kann einem Busteilnehmer die Priorität gegenüber den anderen Busteilnehmern eingeräumt werden. Dadurch wird das Netzwerkverhalten planbar/vorhersagbar und damit echtzeitfähig. Randbedingung ist, dass jedem Gerät ein eindeutiger Geräte-Identifizierer zugewiesen wird.

Dabei ist es von Vorteil, wenn der Abschnitt mit den höherwertigen Bits für die Priorisierung des Botschafts-Inhaltes reserviert wird und der Abschnitt mit den niederwertigen Bits für die Geräte-Identifizierung vorgesehen werden. Dadurch entscheidet sich der Buszugriff, wie beim CAN-Bus, während der Arbitirierungsphase vorwiegend über die mit verschiedener Priorität versehenen Botschaftsinhalte und erst in zweiter Linie über die Geräte ID.

In einer vorteilhaften Variante wird ein 32 Bit langer-Identifizierer so aufgeteilt, dass 24 Bit für die Priorisierung des Botschafts-Inhaltes reserviert werden und 8 Bit für die Priorisierung des Gerätes vorgesehen werden.

Zusammengefasst wird durch die vorgestellten Maßnahmen das CAN-FD Protokoll in einer vorteilhaften Weise erweitert, so dass die niedrigen Hardware-Kosten, wie beim CAN-FD Bus gegeben, beibehalten werden können. Auch das für den Kfz-Bereich so essentielle dezentrale Arbitrierungsverfahren wird beibehalten. Dies ist für die weitere Automobilentwicklung eine Erleichterung, da keine neuen Herstellerübergreifenden Spezifizierungen in diesem Bereich notwendig werden. Durch die Beibehaltung der dezentralen Arbitrierung und die besondere Ausgestaltung des Arbitrierungsfeldes bleibt der erweiterte CAN EL Bus echtzeitfähig, was für den Einsatz im Kfz so wichtig ist.

Durch die bei der Spezifizierung des erweiterten CAN EL Bus-Protokolls eingebaute Variabilität ist das Bus-Protokoll anpassungsfähig an die konkrete Busarchitektur. Je nach geplanter Netzwerkgröße kann die Datenrate angepasst werden, um so eine kostenoptimale Architektur umsetzen zu können. Beispielsweise kann der erweiterte Bus sogar den Sonderfall eines kleinen Netzwerkes mit nur 2 Teilnehmern (Punkt zu Punkt Verbindung) abdecken. Dabei könnte die Datenübertragung mit sehr hoher Datenrate realisiert werden.

Für eine entsprechend ausgelegte Busschnittstelle zur Verwendung bei dem vorgeschlagenen Verfahren zur Übertragung von Daten über einen seriellen Kommunikationsbus gelten die entsprechenden Vorteile wie im Zusammenhang mit den entsprechenden Verfahrensschritten erläutert.

Das Gleiche gilt für ein entsprechend ausgelegtes Computerprogramm, das bei Abarbeitung in einer Recheneinheit die sendeseitigen Schritte und/oder die empfangsseitigen Schritte des vorgeschlagenen Verfahrens zur Übertragung von Daten durchführt. Zwar spielen im Kfz-Bereich die Hardwarekosten eine zentrale Rolle, so dass hier hauptsächlich weniger leistungsfähige Mikrocontroller eingesetzt werden, die durch separate CAN-Controller unterstützt werden, bei denen das Datenübertragungsprotokoll durch Spezial-Hardware realisiert wird. In anderen Bereichen, z.B. im Feldbusbereich für Automatisierungstechnik oder Prozesstechnik werden auch leistungsfähigere Mikrocontroller eingesetzt, für die dann auch die Softwarelösung zur Implementierung des erweiterten Datenübertragungsprotokolls in Betracht kommt.

Ein Ausführungsbeispiel der Erfindung ist in den Zeichnungen dargestellt und wird nachfolgend anhand der Figuren näher erläutert.

Es zeigen:
- Fig. 1: das Prinzip der Vernetzung von elektronischen Komponenten mittels CAN-Bus;
- Fig. 2: ein Blockdiagramm für ein Fahrzeug-Bordnetzwerk mit Steuergeräten verschiedener Kategorie;
- Fig. 3: das detaillierte Übertragungsrahmen-Format gemäß einem Ausführungsbeispiel der Erfindung;
- Fig. 4: das Ergebnis der Berechnung der Nettodatenrate für die Übertragung von Daten in Paketen verschiedener Länge gemäß dem vorgeschlagenen Übertragungsrahmen-Format;
- Fig. 5: das Ergebnis der Berechnung der Effizienz für die Übertragung von Daten in Paketen verschiedener Länge gemäß dem vorgeschlagenen Übertragungsrahmen-Format; und
- Fig. 6: ein Beispiel des Ablaufs der Arbitrierungsphase, wenn zwei CAN-Knoten gleichzeitig auf den Bus zugreifen.

Die vorliegende Beschreibung veranschaulicht die Prinzipien der erfindungsgemäßen Offenbarung. Der CAN-Bus wurde schon 1994 standardisiert. Die entsprechende ISO-Norm hat die Nummer ISO 11898. Es gibt eine Norm für den Highspeed-Bereich bis 1 Mbit/s, das ist die Norm ISO 11898-2. Dann gibt es eine Norm für den Lowspeed-Bereich bis 125 kBit/s, das ist die Norm ISO 11898-3. Durch das anwachsende Datenaufkommen ergeben sich immer höhere Buslasten auf den CAN-Bussen. Dies führte zu einer Weiterentwicklung des CAN-Busses. Der erweiterte CAN-Bus ist unter dem Begriff CAN FD-Bus bekannt. FD steht dabei für Flexible Data Rate. Bei dieser CAN-Bus Variante wird die Datenrate umgeschaltet. Für die Arbitrierungsphase bleibt die Datenrate niedrig, wie beim klassischen CAN-Bus. Für die Übertragung der Nutzdaten wird auf eine höhere Datenrate umgeschaltet. Überträgt man die Nutzdaten einer CAN-FD-Botschaft schneller, so verkürzt sich die Dauer der Busbelegung; und die Buslast verringert sich. Wenn die Übertragungsdauer im gleichen Rahmen bleibt wie bei den klassischen CAN-Botschaften, könnten größere Datenmengen mit einer CAN-FD-Botschaft transportiert werden. So wurde es auch bei CAN FD realisiert. Statt des 8 Byte langen Nutzdatenfeldes wird bei CAN FD ein 64 Byte langes Nutzdatenfeld eingesetzt. Die Datenrate steigt für die Übertragung des Nutzdatenfeldes bei einer Umsetzung z.B. von 500 kbit/s auf 2 Mbit/s an.

Analog zum klassischen CAN-Protokoll, kennt z.B. auch der CAN FD Bus zwei Data-Rahmen-Formate: Standard Frames mit 11 Bit Identifizierer und Extended Frames mit 29 Bit Identifizierer. Damit ist gewährleistet, dass Zusatzprotokolle wie CANopen und SAE J1939 mit entsprechenden Anpassungen auch unter CAN FD weiterexistieren und die beschriebenen Vorteile nutzen können.

Für CAN FD wurde darauf verzichtet ein eigenes Format für Remote Frames einzuführen. Dies ist jedoch bei näherem Hinsehen keine Einschränkung. Wegen des fehlenden Datenfeldes wäre eine Erhöhung der Datenrate wirkungslos. Das CAN-FD-Protokoll erlaubt allerdings, CAN FD Data Frames mit klassischen CAN Remote Frames anzufordern.

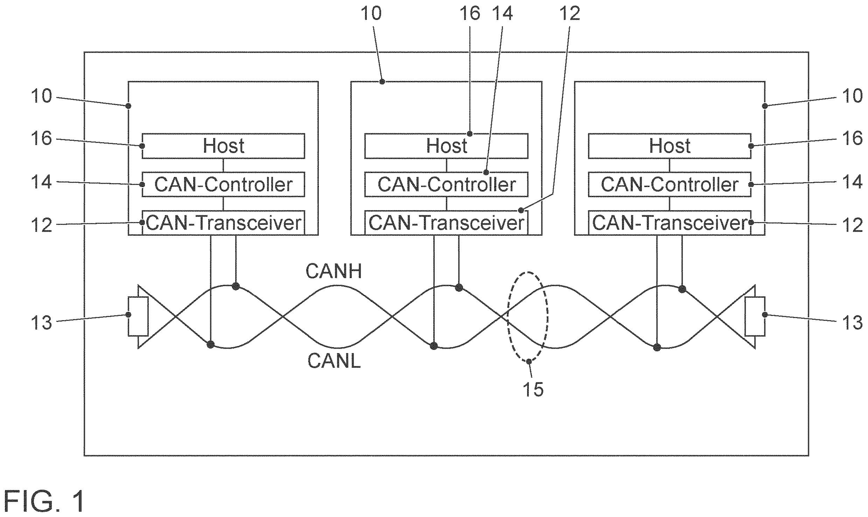

Fig. 1 zeigt das Prinzip der Vernetzung von elektronischen Komponenten mittels CAN-Bus. Ein CAN-Netzwerk ist ein Systemverbund aus CAN-Knoten (elektronische Komponenten (Steuergeräte, Sensoren, Aktoren) mit CAN-Schnittstelle), die über ihre jeweiligen CAN-Schnittstellen und einem alle CAN-Schnittstellen verbindendes Übertragungsmedium (CAN-Bus) untereinander Daten austauschen. Es sind drei CAN-Knoten 10 dargestellt. Die Busstruktur des CAN-Bus ist linear. Es gibt daher eine Busleitung 15 an die alle drei CAN-Knoten 10 angeschlossen sind. Als Busleitung 15 wird in den häufigsten Einsatzfällen eine verdrillte, ungeschirmte Zweidrahtleitung (Unshielded Twisted Pair - UTP) genutzt, über die eine symmetrische Signalübertragung erfolgt. Bei der symmetrischen Signalübertragung werden die Signale als Spannungsdifferenzen über zwei Leitungen übertragen. Das Leitungspaar setzt sich dabei aus einer nicht invertierten CANH und einer invertierten Signalleitung CANL zusammen. Aus der Differenz der auf diesen beiden Drähten anliegenden Signale rekonstruieren die Empfänger das ursprüngliche Datensignal. Dies hat den Vorteil, dass sich Gleichtaktstörungen, die auf beiden Drähten der Busleitung 15 auftreten, durch die Differenzbildung weglöschen und sich so nicht auf die Übertragung auswirken.

Um Signalreflektionen zu vermeiden ist die Busleitung 15 an beiden Leitungsenden mit einem Abschlusswiderstand 13 der Größe des Wellenwiderstandes der Busleitung (120 Ohm) abgeschlossen.

Eine CAN-Schnittstelle setzt sich aus zwei Teilen zusammen: der Kommunikationssoftware und der Kommunikationshardware. Während die Kommunikationssoftware höhere Kommunikationsdienste umfasst, sind die grundlegenden Kommunikationsfunktionen typischerweise in Hardware implementiert: Hier werden zwei Hardware-Komponenten unterschieden: Der CAN-Controller 14 sorgt für die einheitliche Abwicklung des CAN-Kommunikationsprotokolls, und entlastet dadurch den Host 16 auf dem die bereits erwähnte Kommunikationssoftware läuft. Der CAN-Transceiver 12 sorgt für die Ankopplung des CAN-Controllers 14 an den CAN-Bus 15. Er formt die Signale für die Datenübertragung beim Sendevorgang und macht die Signalaufbereitung im Empfangsfall. An diesem prinzipiellen Aufbau ändert sich auch nichts, wenn das CAN FD Busprotokoll eingesetzt wird.

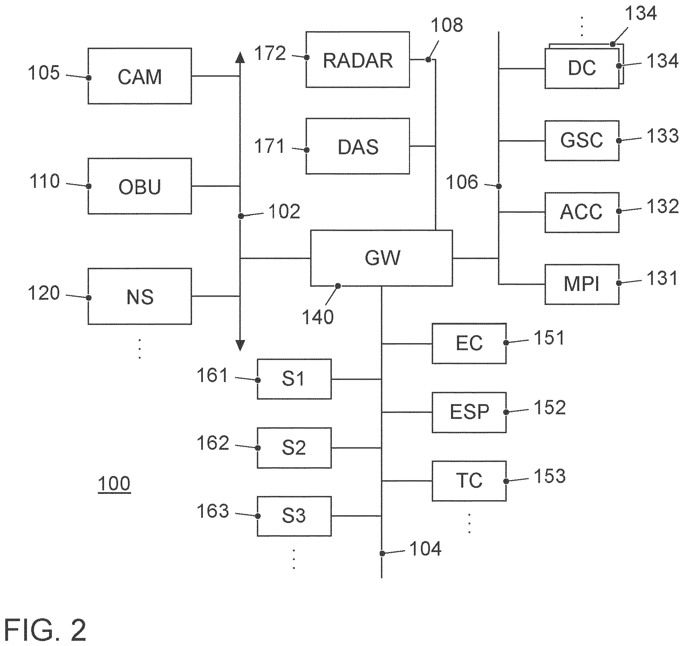

Fig. 2 zeigt den typischen Aufbau eines Bordnetzwerkes eines modernen Kraftfahrzeuges. Mit der Bezugszahl 151 ist ein Motorsteuergerät bezeichnet. Die Bezugszahl 152 entspricht einem ESP-Steuergerät und die Bezugszahl 153 bezeichnet ein Getriebe-Steuergerät. Weitere Steuergeräte wie ein Fahrdynamik-Steuergerät, usw. können im Kraftfahrzeug vorhanden sein. Die Vernetzung solcher Steuergeräte, die alle der Kategorie des Antriebsstrangs zugerechnet werden, geschieht typischerweise mit dem Highspeed CAN-Bussystem (Controller Area Network) 104. Da verschiedene Sensoren im Kraftfahrzeug installiert werden und diese nicht mehr nur an einzelne Steuergeräte angeschlossen werden, werden solche Sensordaten ebenfalls über das Bussystem 104 zu den einzelnen Steuergeräten übertragen. Beispiele von Sensoren im Kraftfahrzeug sind Raddrehzahlsensoren, Lenkwinkelsensoren, Beschleunigungssensoren, Drehratensensoren, Reifendrucksensoren, Abstandssensoren, Klopfsensoren, Luftgütesensoren, usw. Die verschiedenen Sensoren mit dem das Fahrzeug ausgestattet ist, sind in der Figur 2 mit der Bezugszahl 161, 162, 163 bezeichnet. Häufig wird noch ein weiterer CAN-Bus 106 im Fahrzeug eingesetzt über den hauptsächlich Komfortkomponenten vernetzt werden. Das sind z.B. Türsteuergeräte 134, ein Kombiinstrument-Steuergerät 133, eine Klimaanlagensteuerung 132, ein Wählhebel-Steuergerät 131 und andere. Für solche Komponenten reicht üblicherweise die Lowspeed-Variante des CAN-Busses aus.

Das moderne Kraftfahrzeug kann aber noch weitere Komponenten aufweisen wie Videokameras 105, z.B. als Rückfahrkamera oder als Fahrerüberwachungskamera als auch ein LIDAR- oder RADAR-Gerät für die Realisierung eines Radartempomaten oder zur Realisierung eines Abstandswarnungs- oder Kollisionswarnungsgerätes.

Davon unterschieden wird oft ein Navigationssystem 120, welches ebenfalls im Bereich des Cockpits verbaut wird. Die Route, welche auf einer Karte angezeigt wird, kann natürlich ebenfalls auf dem Display im Cockpit dargestellt werden. Weitere Komponenten, wie eine Freisprecheinrichtung können vorhanden sein, sind aber nicht näher dargestellt. Die Bezugszahl 110 bezeichnet noch eine On-Board Unit. Diese On-Bord Unit 110 entspricht einem Kommunikationsmodul über das das Fahrzeug mobile Daten empfangen und senden kann. Typischerweise handelt es sich hier um ein Mobilfunk-Kommunikationsmodul, z. B. nach dem LTE-Standard. All diese Geräte sind dem Infotainment-Bereich zuzuordnen. Sie werden deshalb über ein auf die speziellen Bedürfnisse dieser Gerätekategorie ausgelegtes Bussystem 102 vernetzt. Dieses Bussystem ist nach dem hier vorgeschlagenen erweiterten CAN EL Bus Standard ausgelegt. Als weiteres Beispiel ist noch ein CAN-Bus 108 gezeigt, der nur die beiden Komponenten Fahrerassistenz-Steuergerät 171 und RADAR-Gerät 172 verbindet. Für diesen CAN Bus wird ebenfalls der erweiterte CAN-EL Bus eingesetzt. Dies zeigt den breiten Einsatzbereich des erweiterten CAN-EL Busses. Ein RADAR-Sensor oder LIDAR-Sensor oder eine Anzahl Kameras und/oder Ultraschall-Sensoren kann schon ein erhöhtes Datenaufkommen verursachen. Diese Anforderungen können mit dem CAN EL Bus wie bereits beschrieben erfüllt werden.

Zu dem Zweck, das fahrzeugrelevante Sensordaten über die Kommunikationsschnittstelle 110 zu einem anderen Fahrzeug oder zu einem Zentralrechner übertragen werden sollen, ist das Gateway 140 vorgesehen. Dieses ist mit beiden verschiedenen Bussystemen 102 und 104 verbunden. Das Gateway 140 ist dazu ausgelegt die Daten, die es über den CAN-Bus 104 empfängt so umzusetzen, dass sie in das Übertragungsformat des Infotainment-Busses 102 umgesetzt werden, so dass sie in den dort spezifizierten Paketen verteilt werden können. Für die Weiterleitung dieser Daten nach extern, also zu einem anderen Kraftfahrzeug oder zu einem Zentralrechner ist die On-Board-Unit 110 mit der Kommunikationsschnittstelle dazu ausgerüstet, diese Datenpakete zu empfangen und wiederum in das Übertragungsformat des entsprechend eingesetzten Mobilfunkstandards umzusetzen. Wie dargestellt, ist das Gateway 140 als zentrales Gerät sowohl an den Highspeed CAN Bus 104, als auch an den Lowspeed CAN-Bus 106 wie auch an den CAN EL Bus 102 und 108 angeschlossen. Es übernimmt daher alle notwendigen Format-Umsetzungen, wenn Daten zwischen den verschiedenen Bussystemen ausgetauscht werden sollen.

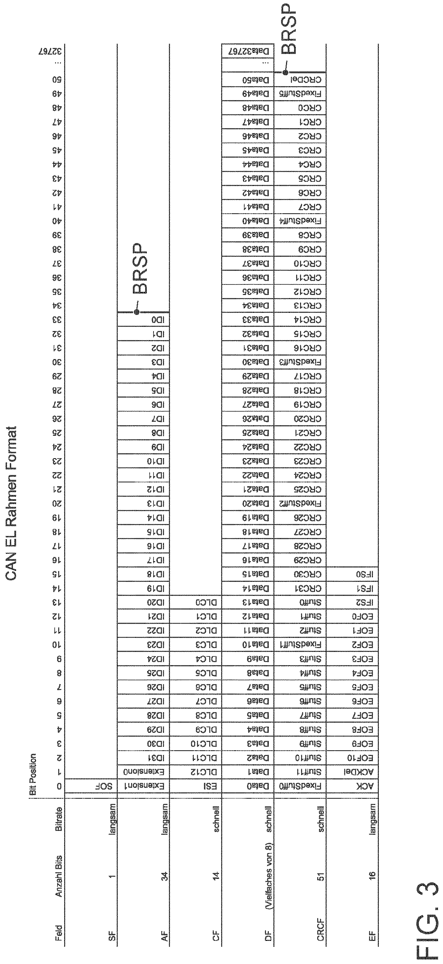

Fig. 3 zeigt das neue Übertragungsrahmen-Format gemäß CAN EL Bus-Standard. Der Vorschlag basiert auf dem Botschaftslayout der MAC Frames wie es in der ISO Spezifikation ISO 11898-1 von 2015 in Kapitel 10.4 beschrieben ist. Dabei bleibt die Funktionalität und Bedeutung der einzelnen Felder erhalten, wenn hier nicht explizit auf Abweichungen eingegangen wird.

Es sind viele verschiedene einzelne Bits im Übertragungsrahmen nach ISO 11898-1 vorhanden, die Steuerungszwecke erfüllen. Vorbereitend werden die verschiedenen Steuerungsbits mit ihrer Bezeichnung in englischer Sprache in der folgenden Tabelle aufgelistet. Bei der nachfolgenden Erwähnung dieser Bits wird die ausführliche Bezeichnung nicht mehr wiederholt.

| Control Bit | Ausführliche Bezeichnung |
|---|---|
| SOF | Start of Frame |
| SRR | Substitute Remote Request |
| RTR | Remote Transmission Request |
| RRS | Remote Request Substitution |
| IDE | Identifier Extension |
| FDF | Flexible Data Rate Format Indicator |
| BRS | Bit Rate Switch |
| ESI | Error State Indicator |
| EOF | End of Frame |

Die Darstellung ist dabei so gewählt, dass die einzelnen Bits pro Feld des Übertragungsrahmens jeweils in einer Zeile angegeben sind. Mit erhöhter Datenübertragungsrate werden die Felder Control Field, Data Field und CRC Field übertragen. Die erhöhte Datenübertragungsrate liegt zwischen 2000 KBit/s und 12000 KBit/s. Die Schrittweite zur Einstellung der Datenübertragungsrate beträgt 1000 KBit/s. Für die anderen Teile des Übertragungsrahmens, nämlich "Start Field", "Arbitration Field" und "End Field" gilt nach wie vor die niedrige Datenübertragungsrate, die auch beim CAN FD Bus eingesetzt wird, d.h. die Datenübertragungsrate darf zwischen 500 KBit/s und 1500 KBit/s liegen. Die Schrittweite zur Einstellung der Datenübertragungsrate beträgt hier 250 KBit/s.

Abweichend von der genannten Spezifikation wird neu nur noch ein Übertragungsrahmen-Format unterstützt. Das neue Übertragungsrahmen-Format beruht auf dem Format FEFF ("FD Extended Frame Format").

Das Start-Feld SF mit dem SOF-Bit bleibt unverändert.

Nach dem Start-Feld SF werden das Extension0 Bit und das Extension1 Bit, welche für zukünftige Erweiterungen reserviert sind, in das Arbitrierungs-Feld AF eingefügt. Diese Bits sind in dem FEFF-Format nicht vorhanden. Beide Bits Extension0 und Extension1 werden mit "rezessivem" Buspegel übertragen.

Der Abschnitt für den Identifizierer in dem Arbitrierungs-Feld AF wird auf 32 Bit erweitert. Die 32 Bit des Identifizierer Abschnitts werden am Stück übertragen und nicht mehr wie bei CAN FD in 2 verschiedenen Abschnitten. Dementsprechend entfallen auch die sonst zum Zweck der Übertragungsrahmen-Formatsteuerung vorgesehenen Bits SRR, RTR, RRS und IDE.

Im Steuerungs-Feld CF wird der Abschnitt für die Längenangabe des Datenfeldes auf eine Länge von 13 Bit erweitert. In den Bits DL0 bis DL12 wird die Länge des Nutzdatenfeldes in der Anzahl der Bytes angegeben. Damit gibt der numerische Wert in diesem Abschnitt exakt die Anzahl an Bytes im Nutzdatenfeld an. Mit 13 Bit kann die maximale Anzahl von 8192 Bytes kodiert werden. Es kann aber auch jede beliebige andere ganze Zahl in dem Bereich damit kodiert werden. Die Länge des Datenfeldes soll bis zu 4096 Byte umfassen, damit ein entsprechendes Ethernet-Paket darin Platz finden kann. Der Bereich des Control Felds mit der Längenangabe für das Datenfeld DF kann zwar mit 13 Bit mehr Bytes angeben, es wird aber über eine Festlegung auf 4096 Bytes begrenzt.

Es dürfen also in das verlängerte Daten-Feld DF innerhalb der festgelegten Obergrenze von 4096 eine beliebige Anzahl von Bytes eingetragen werden.

Die Steuerungsbits FDF, BRS und das reservierte res Bit zwischen und Steuerungs-Feld CF und Daten-Feld DF entfallen. Nur das ESI Bit bleibt an dieser Position als Steuerungs-Bit erhalten.

Das Daten-Feld DF selbst kann variable Länge aufweisen. Hier können je nach dem was eingestellt wird bis maximal 4096 Bytes folgen. Das entspricht einer Länge von 32768 Bits.

Das CRC-Feld CF in dem der CRC Prüfcode eingetragen wird, wird auf eine CRC Länge von 32 Bit erweitert. Der Prüfcode wird in die Bit-Felder CRC0 bis CRC31 eingetragen.

Zur Berechnung des CRC-Prüfcodes wird das Polynom G(x) = x32 + x26 + x23 + x22 + x16 + x12 + x11 + x10 + x8 + x7 + x5 + x4 + x2 + x + 1 verwendet.

Dabei entspricht das gewählte Polynom dem Polynom, welches in der Spezifikation IEEE 802.3 für Ethernet verwendet wird.

Die CRC Prüfsumme ist vom SOF-Bit bis zum letzten Bit des Stuff Bit Counters (Stuff0) zu berechnen.

Der Abschnitt Stuff Count im CRC Feld CF wird auf eine Länge von 12 Bit geändert und betrifft die Bits Stuff0 bis Stuff 11. In den Abschnitt Stuff Count wird die Anzahl der in dem Bereich vom SOF-Bit bis zum letzten Bit des Daten-Feldes DF eingefügten Stuffbits eingetragen. Dabei wird die Anzahl der Stuffbits binär kodiert. Der Einsatz des Bit-Stuffing ist gegenüber dem beim CAN-FD Standard eingesetzten Bit-Stuffing allerdings vereinfacht. Auch in diesem Punkt wurde der CAN-EL Bus gegenüber dem CAN-FD Bus optimiert, wie im Folgenden im Einzelnen beschrieben.

Die Einfügung von Stuffbits dient dem Zweck der Synchronisation bei asynchroner Datenübertragung. Zur Herstellung des Gleichlaufs der Kommunikationspartner dient die von rezessiv nach dominant wechselnde Signalflanke des Startbits SOF einer CAN-Botschaft. Ein Resynchronisationsmechanismus sorgt im Anschluss an das SOF-Bit für die Beibehaltung des Gleichlaufs. Der Resynchronisationsmechanismus basiert auf der Auswertung der von rezessiv nach dominant wechselnden Signalflanken. Damit hier die Synchronisation beibehalten wird, wurde im CAN-Standard der Bitstuffingmechanismus eingefügt. In der ISO Norm ISO 11898-1 ist spezifiziert, dass spätestens nach fünf homogenen Bits ein komplementäres Bit zu übertragen ist, auch dann, wenn nach fünf homogenen Bits ohnehin ein komplementäres Bit folgen würde. Die Lage der Stuffbits ist dem Empfänger aufgrund der Regel bekannt und er kann die Stuffbits ignorieren.

Der Bitstuffing Algorithmus (Frame Encoding) für das neue Übertragungsformat wird insofern abgewandelt, dass ein Stuffbit nicht nach 5 sondern erst nach 10 unmittelbar aufeinander folgenden Bits mit dem gleichen Bus-Pegel eingefügt wird. Es werden dadurch weniger Overhead-Bits im Datenrahmen benötigt und es wird dadurch die Effizienz der Datenübertragung gesteigert.

Das variable Bitstuffing ist nur für die Bits vom SOF bis zum letzten Bit des Data Feldes DF durchzuführen. Ab dem CRC Feld CF werden vordefinierte Stuffbits (FixedStuffx) verwendet. Die FixedStuff-Bits werden immer nach 9 Bits eingefügt.

Es handelt sich um die Bits FixedStuff0, FixedStuff1, FixedStuff2, FixedStuff3, FixedStuff4 und FixedStuff5. Die einzelnen Stuffbits in dem CRC-Feld sind jeweils mit dem entgegengesetzten Pegel des direkt davor übertragenen Bits zu übertragen.

Durch diese fest vorgegebenen Stuffbits FixedStuff0, FixedStuff1, FixedStuff2, FixedStuff3, FixedStuff4 und FixedStuff5 wird ein garantierter Flankenwechsel bei der Übertragung an der gewünschten Stelle bewirkt.

Das Bit FixedStuff0 wird zwischen dem letzten Daten Bit und dem Bit Stuff11 übertragen.

Das Bit FixedStuff1 wird zwischen dem Bit Stuff3 und dem Bit Stuff2 übertragen.

Das Bit FixedStuff2 wird zwischen dem Bit CRC26 und dem Bit CRC25 übertragen.

Das Bit FixedStuff3 wird zwischen dem Bit CRC17 und dem Bit CRC16 übertragen.

Das Bit FixedStuff4 wird zwischen dem Bit CRC8 und dem Bit CRC7 übertragen.

Das Bit FixedStuff5 wird zwischen dem Bit CRC0 und dem Bit CRCDel übertragen.

Das CRCDel Bit, was die Funktion eines CRC Delimiters innehat, bleibt unverändert und hat die gleiche Funktion wie im CAN FD Standard.

Im Ende-Feld EF bleiben beide Bits ACK und ACKDel unverändert.

Im Ende-Feld EF wird der Abschnitt mit der EOF Kennzeichnung auf 11 Bit erweitert. Hier werden also statt der beim CAN Bus üblichen 7 aufeinander folgenden rezessiven Bits 11 rezessive Bits übertragen. Die Verlängerung des EOF-Symbols ist der Modifikation des Stuffing Algorithmus geschuldet. Erst nach 11 aufeinander folgenden Bits gleichen Buspegels wird die neue Stuffing-Regel verletzt. Dies wird hier ausgenutzt.

Beim CAN Bus und CAN FD Bus wird zwischen zwei übertragenen Datenrahmen ein sogenanntes Intermission Feld eingefügt. Hier werden nochmals 3 aufeinanderfolgende rezessive Bits IFS2 bis IFS0 übertragen. Daran erkennen die CAN Controller, dass der Bus wieder freigegeben ist. Diese Regel wird auch beim CAN EL Übertragungsformat beibehalten.

Wie beschrieben, werden 2 verschiedene Bitraten für die Übertragung der Bits im Übertragungsrahmen eingesetzt. Die genaue Umschaltposition ist in der Fig. 3 durch das Bezugszeichen BRSP angegeben.

Die langsamere Bitrate wird als Bit Rate Langsam bezeichnet.

Die schnellere Bitrate wird als Bit Rate Schnell bezeichnet.

Für die Bit Rate Langsam wird ein Bereich zwischen 500 KBit/s und 1500 KBit/s festgelegt. Dabei sollen alle Bitraten in 250 KBit/s Schritten unterstützt werden.

Für die Bit Rate Schnell wird ein Bereich zwischen 2000 KBit/s und 12000 KBit/s festgelegt. Dabei sollen in diesem Bereich alle Bitraten in 1000 KBit/s Schritten unterstützt werden.

Höhere Bitraten für die Bit Rate Langsam und Bit Rate Schnell können optional unterstützt werden.

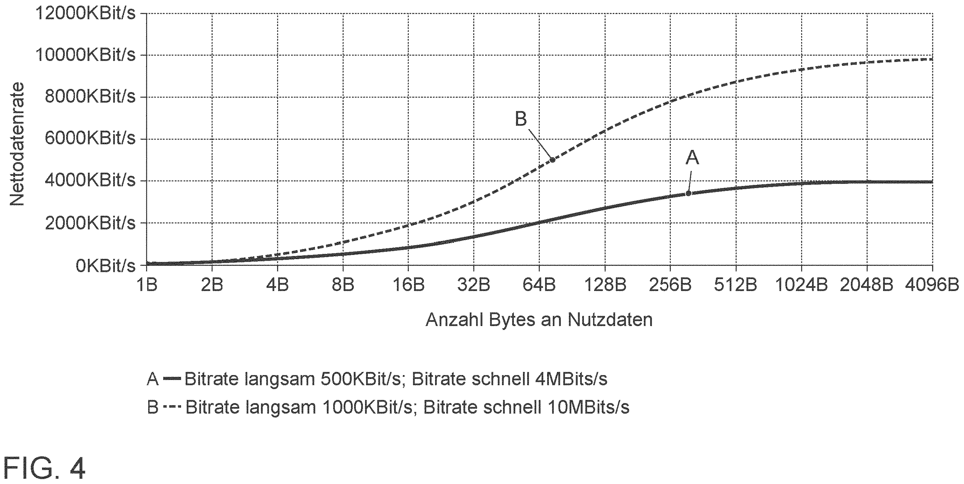

Eine beispielhafte Berechnung der daraus resultierenden Nettodatenraten ist in Fig. 4 gezeigt. Darin wird entlang der Abszisse die Anzahl der im Übertragungsrahmen übertragenen Nutzdatenbytes bis zur vollen Paketlänge mit 4096 Bytes an Nutzdaten aufgetragen. Entlang der Ordinate wird die resultierende Nettodatenrate aufgetragen. Bei der Berechnung wurden allerdings die Stuffbits unberücksichtigt gelassen. Für die untere Kurve A gilt, dass als Bit Rate Langsam 500 KBit/s eingestellt wurde und als Bit Rate Schnell 4 MBit/s. Für die obere Kurve B gilt, dass als Bit Rate Langsam 1000 KBit/s eingestellt wurde und als Bit Rate Schnell 10 MBit/s.

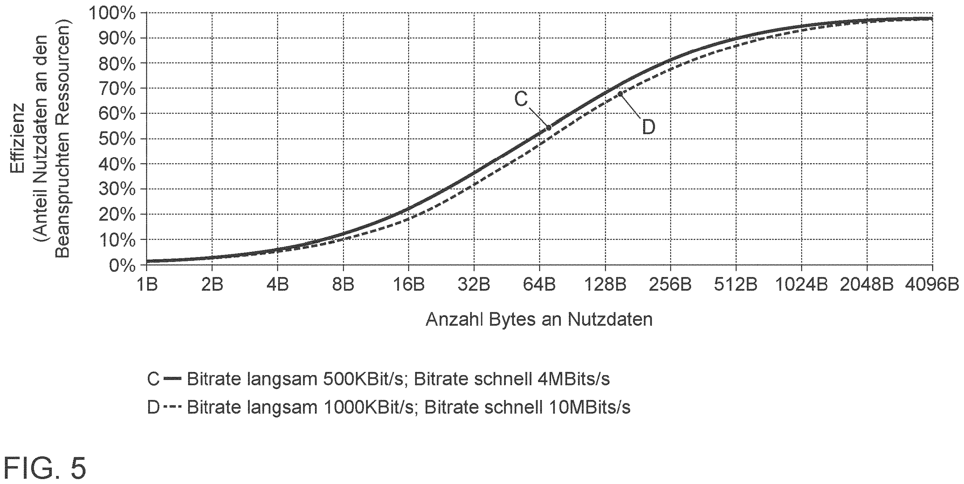

In Fig. 5 ist das Ergebnis einer beispielhaften Berechnung der Datenübertragungseffizienz dargestellt. Darin wird entlang der Abszisse die Anzahl der im Übertragungsrahmen übertragenen Nutzdatenbytes bis zur vollen Paketlänge mit 4096 Bytes an Nutzdaten aufgetragen. Entlang der Ordinate wird die resultierende Effizienz als Prozentangabe aufgetragen. Bei der Berechnung wurden allerdings die Stuffbits unberücksichtigt gelassen. Für die obere Kurve C gilt, dass als Bit Rate Langsam 500 KBit/s eingestellt wurde und als Bit Rate Schnell 4 MBit/s. Für die untere Kurve D gilt, dass als Bit Rate Slow 1000 KBit/s eingestellt wurde und als Bit Rate Schnell 10 MBit/s.

Die Festlegung der Identifizierer für die CAN Botschaften unterliegt grundsätzlich keinerlei Beschränkungen.

Unter Berücksichtigung des Ziels, den CAN Bus für die Übertragung von IP-Paketen zu optimieren, ist es hilfreich eine Vergaberichtlinie hinsichtlich der ID-Vergabe anzuwenden. Die Befolgung der Vergaberichtlinie ist insbesondere für den Bereich der IP Kommunikation vorteilhaft.

Wie beim CAN Bus und CAN FD wird der Identifizierer zur Realisierung eines Priorisierungskonzeptes verwendet. Anhand des Identifizierers entscheidet sich welcher CAN-Knoten sich auf dem Bus durchsetzt. Das Buszugriffsverfahren entspricht dem CSMA-CR Verfahren (Carrier Sense Multiple Access with Collision Resolution). Das CSMA/CR-Verfahren sorgt dafür, dass sendewillige CAN-Knoten erst dann auf den CAN-Bus zugreifen, wenn dieser frei ist. Bei simultanen Buszugriffen sorgt die dem CSMA/CR-Verfahren zugrundeliegende Methode der bitweisen Busarbitrierung dafür, dass sich immer jener CAN-Knoten mit der höchst prioren CAN-Botschaft durchsetzt. Prinzipiell gilt: je höher die Priorität einer CAN-Botschaft, desto eher kann sie auf dem CAN-Bus übertragen werden. Niederpriore CAN-Botschaften laufen bei ungünstigem Systemdesign sogar Gefahr, gar nicht übertragen zu werden. Deshalb ist die Vergabe der IDs sehr wichtig für die Realisierung eines deterministischen Datenaustausches.

Nach dem neuen Konzept werden die 32 Bit des Identifizierers in zwei Bereiche [Botschafts-Inhalt] und [Gerät] unterteilt.

Der Bereich [Botschafts-Inhalt] umfasst die höherwertigen Bits des Identifizierers. Der Bereich [Gerät] umfasst die niederwertigen Bits des Identifizierers.

Die Größe der einzelnen Bereiche kann bedarfsgerecht gewählt werden, muss aber innerhalb eines CAN Netzwerks für alle Teilnehmer gleich sein. In einer beispielhaften Ausführungsform werden 24 Bit für den Bereich [Botschafts-Inhalt] reserviert und 8 Bit für den Bereich [Gerät]. Damit ist es möglich eine feine Differenzierung hinsichtlich der Priorität von Botschaften im Netzwerk vorzunehmen. Sollten zwei Teilnehmer zum gleichen Zeitpunkt eine Botschaft mit der gleichen Priorität senden wollen, entscheidet es sich im Bereich [Gerät], welcher Teilnehmer den Vorzug erhält.

Eine niedrigere Binärzahl im Bereich [Botschafts-Inhalt] bzw. [Gerät] entspricht einer tatsächlich höheren Priorität. Auf dem CAN Bus setzt sich in der Arbitrierungsphase immer der dominante Buspegel durch. Ein CAN Knoten, der erkennt, dass er selbst nur den rezessiven Buspegel gesendet hat und aber erkennt, dass der dominante Pegel anliegt, gibt bei der Arbitrierung auf.

Durch die entsprechende Vergabe der Device ID kann einem Busteilnehmer die Priorität gegenüber den anderen Busteilnehmern eingeräumt werden. Dadurch wird das Netzwerk verhalten vorhersagbar und damit echtzeitfähig.

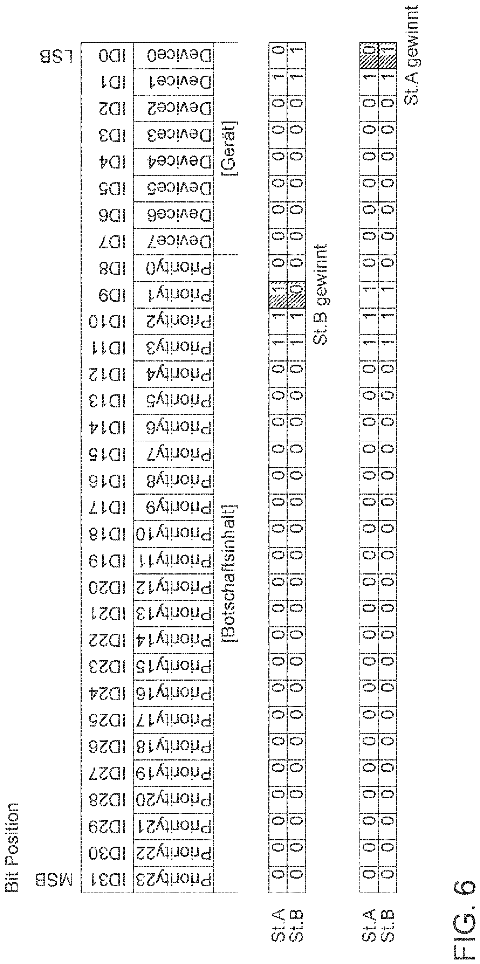

Fig. 6 illustriert den Vorgang der Arbitrierung:
Im oberen Teil der Darstellung sind die einzelnen Bit Positionen des Arbitirierungs-Feldes AF von 0 bis 31 durchnummeriert. Im [Botschaftsinhalt]-Bereich wird für jedes Bit auch angegeben welche Priorität mit der einzelnen Bit-Position verbunden ist. Der Bit-Position ID8 kommt im [Botschaftsinhalt]-Bereich die niedrigste Priorität Priority0 zu und der Bit-Position ID31 dementsprechend die höchste Priorität Priority23 im [Botschaftsinhalt]-Bereich. Ebenso hat das Bit mit der Nummer ID0 im [Gerät]-Bereich die niedrigste Priorität und das Bit mit der Nummer ID7 dann die höchste Priorität.

Im mittleren Bereich der Fig. 6 ist ein Arbitrierungsvorgang dargestellt wo zwei Steuergeräte St. A und St. B um den Bus konkurrieren. Dem Steuergerät St.A wurde die Device ID 00000010b zugewiesen und dem Steuergerät St.B wurde die Device ID 00000011b zugewiesen. In diesem Fall entscheidet sich die Busvergabe im Bereich [Botschafts-Inhalt]. Im dargestellten Fall gewinnt der Teilnehmer St. B weil er im Bit ID9 eine "0" eingetragen hat und der Teilnehmer St. A dort eine "1" eingetragen hat. Eine eingetragene "0" entspricht beim CAN-Bus dem dominanten Buspegel.

Im unteren Bereich der Fig. 6 ist ein Arbitrierungsvorgang dargestellt wo wiederum die zwei Steuergeräte St. A und St. B um den Bus konkurrieren. Im Bereich [Botschafts-Inhalt] senden beide Teilnehmer dieselbe CAN-Botschaft, hier wird also im Bereich [Botschafts-Inhalt] dieselbe ID gesendet. Dadurch entscheidet sich die Busvergabe in diesem Fall erst im Bereich [Gerät]. Im dargestellten Fall gewinnt der Teilnehmer St. A weil er im letzten Bit mit der Nummer ID0 eine "0" eingetragen hat und der Teilnehmer St. B dort eine "1" eingetragen hat.

Die Offenbarung ist nicht auf die hier beschriebenen Ausführungsbeispiele beschränkt. Es gibt Raum für verschiedene Anpassungen und Modifikationen, die der Fachmann aufgrund seines Fachwissens als auch zu der Offenbarung zugehörend in Betracht ziehen würde.

Alle hierin erwähnten Beispiele wie auch bedingte Formulierungen sind ohne Einschränkung auf solche speziell angeführten Beispiele zu verstehen. So wird es zum Beispiel von Fachleuten anerkannt, dass das hier dargestellte Blockdiagramm eine konzeptionelle Ansicht einer beispielhaften Schaltungsanordnung darstellt.

Es sollte verstanden werden, dass das vorgeschlagene Verfahren und die zugehörigen Vorrichtungen in verschiedenen Formen von Hardware, Software, Firmware, Spezialprozessoren oder einer Kombination davon implementiert werden können. Spezialprozessoren können anwendungsspezifische integrierte Schaltungen (ASICs), Reduced Instruction Set Computer (RISC) und / oder Field Programmable Gate Arrays (FPGAs) umfassen. Vorzugsweise wird das vorgeschlagene Verfahren und die Vorrichtung als eine Kombination von Hardware und Software implementiert. Die Software wird vorzugsweise als ein Anwendungsprogramm auf einer Programmspeichervorrichtung installiert. Typischerweise handelt es sich um eine Maschine auf Basis einer Computerplattform die Hardware aufweist, wie beispielsweise eine oder mehrere Zentraleinheiten (CPU), einen Direktzugriffsspeicher (RAM) und eine oder mehrere Eingabe/Ausgabe (I/O) Schnittstelle(n). Auf der Computerplattform wird typischerweise außerdem ein Betriebssystem installiert. Die verschiedenen Prozesse und Funktionen, die hier beschrieben wurden, können Teil des Anwendungsprogramms sein, oder ein Teil der über das Betriebssystem ausgeführt wird.

### Bezugszeichenliste

- 10: CAN-Knoten
- 12: CAN-Transceiver
- 13: Abschlusswiderstand
- 14: CAN-Controller
- 15: Busleitung
- 16: Host
- 100: Kfz-Elektronik
- 102: Infotainment-CAN-Bus
- 104: Highspeed CAN-Bus
- 105: Kamera
- 106: Lowspeed CAN-Bus
- 108: Fahrerassistenz-CAN-Bus
- 110: Kommunikationsmodul
- 120: Navigationssystem
- 131: Bedienungseinheit
- 132: Klimaanlagen-Steuergerät
- 133: Wählhebel-Steuergerät
- 134: Türsteuergerät
- 140: Gateway
- 151: Motor-Steuergerät
- 152: ESP-Steuergerät
- 153: Getriebe-Steuergerät
- 161: Sensor 1
- 162: Sensor 2
- 163: Sensor 3
- 171: Fahrerassistenz-Steuergerät
- 172: RADAR-Steuergerät
- A: 1. Beispielkurve
- B: 2. Beispielkurve
- C: 3. Beispielkurve
- D: 4. Beispielkurve
- St. A: Station A
- St. B: Station B
- BRSP: Bitraten-Umschaltpunkt

## Patentansprüche

1. Verfahren zur Übertragung von Daten über einen seriellen Kommunikationsbus, bei dem die Daten mit einem Übertragungsrahmen übertragen werden,
wobei der Übertragungsrahmen wenigstens ein Arbitrierungs-Feld (AF) und ein Daten-Feld (DF) aufweist, wobei das Arbitrierungs-Feld (AF) zur Regelung des Buszugriffs nach dem CSMA-CR Verfahren, entsprechend Carrier Sense Multiple Access with Collision Resolution durch Priorisierung der Botschaften mit Hilfe eines Identifizierers dient,
wobei für die Arbitrierungsphase eine niedrige Bitrate eingestellt wird und für die Übertragung der Daten im Datenfeld (DF) eine erhöhte Bitrate eingestellt wird, wobei das Datenfeld (DF) innerhalb einer festgelegten Obergrenze, die größer als 64 Bytes ist, eine variable Länge für eine beliebige Anzahl von Bytes aufweist, **dadurch gekennzeichnet, dass**
im Übertragungsrahmen weiterhin ein Ende-Feld (EF) vorgesehen wird und in das Ende-Feld (EF) wenigstens ein End-of-Frame-Code eingetragen wird, wobei der End-of-Frame-Code eine Länge von 11 Bit aufweist, um durch Senden des End-of-Frame Codes eine Verletzung einer neuen Bitstuffing-Regel zu erzwingen, so dass Teilnehmer, die nicht korrekt synchronisiert waren, diese Tatsache erkennen.

2. Verfahren nach Anspruch 1, wobei die festgelegte Obergrenze den Wert von 4096 Bytes betrifft.

3. Verfahren nach Anspruch 1 oder 2, wobei die Länge des Arbitrierungs-Feldes (AF) auf 32 Bit festgelegt wird.

4. Verfahren nach einem der vorhergehenden Ansprüche, wobei im Übertragungsrahmen ein Steuerungs-Feld (CF) zwischen Arbitrierungs-Feld (AF) und Daten-Feld (DF) vorgesehen wird, in dem wenigstens ein Abschnitt für die Längenangabe bzgl. des Daten-Feldes (DF) vorgesehen wird.

5. Verfahren nach einem der vorhergehenden Ansprüche, wobei im Übertragungsrahmen ein CRC-Feld (CRCF) vorgesehen wird, in dem wenigstens ein Abschnitt für den CRC-Prüfcode vorgesehen wird.

6. Verfahren nach Anspruch 5, wobei im Übertragungsrahmen ein Start-Feld (SF) vorgesehen wird und der CRC-Prüfcode über die Felder Start-Feld (SF), Arbitrierungs-Feld (AF), Steuerungs-Feld (CF) und Daten-Feld (DF) berechnet wird.

7. Verfahren nach Anspruch 6, wobei die Übertragung der Daten asynchron erfolgt und zur Gewährleistung des Gleichtaktes von Datensende-Station und Datenempfangs-Station eine Resynchronisation nach einer Bitstuffing-Regel durchgeführt wird, wobei die Bitstuffing-Regel über die Bereiche vom Start-Feld (SF) bis zum Ende des Daten-Feldes (DF) angewendet wird, wobei die Bitstuffing-Regel besagt, dass ein Stuffbit erst nach einer definierten Zahl von unmittelbar aufeinander folgenden Bits mit dem gleichen Bus-Pegel eingefügt wird, wobei die definierte Zahl eine natürliche Zahl größer der Zahl 5 ist, wobei die Anzahl der eingefügten Stuff-Bits in einem Abschnitt des CRC-Feldes (CRCF) eingetragen wird.

8. Verfahren nach einem der vorhergehenden Ansprüche, wobei im CRC-Feld (CRCF) an fest vorgegebenen Positionen ein Stuff-Bit eingefügt wird.

9. Verfahren nach Anspruch 8, wobei das CRC-Feld (CRCF) mit einem fest vorgegebenen Stuff-Bit beginnt und die weiteren fest vorgegebenen Stuff-Bits im Abstand von jeweils 9 Bits des CRC-Feldes (CRCF) eingefügt werden.

10. Verfahren nach einem der vorhergehenden Ansprüche, wobei der Identifizierer im Arbitrierungs-Feld (AF) in die Abschnitte "Botschafts-Inhalt"-Identifizierer und "Geräte"-Identifizierer unterteilt wird.

11. Verfahren nach Anspruch 10, wobei der Abschnitt mit den höherwertigen Bits für die Priorisierung des Botschafts-Inhaltes reserviert wird und der Abschnitt mit den niederwertigen Bits für die Geräte-Identifizierung vorgesehen werden.

12. Verfahren nach Anspruch 11, wobei der Identifizierer eine Länge von 32 Bit aufweist und der Abschnitt mit den höherwertigen Bits eine Länge von 24 Bits und der Abschnitt mit den niederwertigen Bits eine Länge von 8 Bits aufweist.

13. Busschnittstelle ausgelegt für die Verwendung bei dem Verfahren nach einem der vorhergehenden Ansprüche.

14. Computerprogramm, **dadurch gekennzeichnet, dass** das Computerprogramm ausgelegt ist bei Abarbeitung in einer Recheneinheit die sendeseitigen Schritte und/oder die empfangsseitigen Schritte des Verfahrens zur Übertragung von Daten nach einem der Ansprüche 1 bis 12 durchzuführen.

## Claims

1. Method for transmitting data via a serial communications bus in which the data is transmitted with a transmission frame,
wherein the transmission frame has at least one arbitration field (AF) and one data field (DF), wherein the arbitration field (AF) serves to regulate the bus access according to the CSMA-CR method, corresponding to carrier sense multiple access with collision resolution, by prioritizing the messages with the aid of an identifier,
wherein a low bit rate is configured for the arbitration phase, and an increased bit rate is configured for the transmission of the data in the data field (DF), wherein the data field (DF), within a fixed upper limit that is greater than 64 bytes, has a variable length for an arbitrary number of bytes,
**characterized in that**
an end field (EF) is also provided in the transmission frame, and at least one end-of-frame code is entered in the end field (EF), wherein the end-of-frame code has a length of 11 bits, in order to force an infringement of a new bit-stuffing rule by sending the end-of-frame code so that participants that were not correctly synchronized recognize this fact.

2. Method according to claim 1, wherein the set upper limit relates to the value of 4,096 bytes.

3. Method according to claim 1 or 2, wherein the length of the arbitration field (AF) is set at 32 bits.

4. Method according to one of the preceding claims, wherein, in the transmission frame, between the arbitration field (AF) and the data field (DF), a control field (CF) is provided, in which at least one portion is provided for specifying the length relating to the data field (DF).

5. Method according to one of the preceding claims, wherein, in the transmission frame, a CRC field (CRCF) is provided, in which at least one section is provided for the CRC verification code.

6. Method according to claim 5, wherein a start field (SF) is provided in the transmission frame, and the CRC verification code is calculated via the fields:
start field (SF), arbitration field (AF), control field (CF), and data field (DF).

7. Method according to claim 6, wherein the transmission of the data occurs asynchronously, and a resynchronization is performed according to a bit-stuffing rule in order to ensure the common mode of data sending station and data receiving station, wherein the bit-stuffing rule is applied over the regions from the start field (SF) to the end of the data field (DF), wherein the bit-stuffing rule states that a stuff-bit is inserted only after a defined number of immediately consecutive bits having the same bus level, wherein the defined number is a natural number greater than the number 5, wherein the number of inserted stuff-bits is entered in a portion of the CRC field (CRCF).

8. Method according to one of the preceding claims, wherein a stuff-bit is inserted in the CRC field (CRCF) at rigidly predetermined positions.

9. Method according to claim 8, wherein the CRC field (CRCF) begins with a rigidly predetermined stuff-bit, and the further rigidly predetermined stuff-bits are inserted in each case at an interval of 9 bits of the CRC field (CRCF).

10. Method according to one of the preceding claims, wherein the identifier in the arbitration field (AF) is divided into the portions, "message content" identifiers and "devices" identifiers.

11. Method according to claim 10, wherein the portion with the higher value bits is reserved for prioritizing the message content, and the portion with the lower value bits is provided for identifying the devices.

12. Method according to claim 11, wherein the identifier has a length of 32 bits, and the portion with the higher value bits has a length of 24 bits, and the portion with the lower value bits has a length of 8 bits.

13. Bus interface designed for use in the method according to one of the preceding claims.

14. Computer program, **characterized in that** the computer program is designed, when being processed in a computing unit, to carry out the sending steps and/or the receiving steps of the method for transmitting data according to one of claims 1 through 12.

## Revendications

1. Procédé de transmission des données par l'intermédiaire d'un bus de communication série, dans lequel les données sont transmises avec une trame de transmission,
la trame de transmission présentant au moins un champ d'arbitrage (AF) et un champ de données (DF), le champ d'arbitrage (AF) servant au réglage de l'accès au bus selon le procédé CSMA-CR, correspondant à Carrier Sense Multiple Access with Collision Resolution, par la priorisation des messages à l'aide d'un identificateur,
un faible débit binaire étant réglé pour la phase d'arbitrage, et un débit binaire accru étant réglé pour la transmission des données dans le champ de données (DF), le champ de données (DF) présentant, dans une limite supérieure fixée qui est supérieure à 64 octets, une longueur variable pour un nombre arbitraire d'octets,
**caractérisé en ce que**
un champ de fin (EF) est en outre prévu dans la trame de transmission, et qu'au moins un code de fin de trame est inscrit dans le champ de fin (EF), le code de fin de trame présentant une longueur de 11 bits, afin de forcer une violation d'une nouvelle règle de bourrage de bits par l'envoi du code de fin de trame, de sorte que des participants qui n'étaient pas synchronisés correctement reconnaissent ce fait.

2. Procédé selon la revendication 1, dans lequel la limite supérieure fixée concerne la valeur de 4096 octets.

3. Procédé selon la revendication 1 ou 2, dans lequel la longueur du champ d'arbitrage (AF) est fixée à 32 bits.

4. Procédé selon l'une quelconque des revendications précédentes, dans lequel un champ de commande (CF) est prévu dans la trame de transmission entre le champ d'arbitrage (AF) et le champ de données (DF), dans lequel au moins une section est prévue pour l'indication de la longueur par rapport au champ de données (DF).

5. Procédé selon l'une quelconque des revendications précédentes, dans lequel un champ de CRC (CRCF) est prévu dans la trame de transmission, dans lequel au moins une section est prévue pour le code de contrôle CRC.

6. Procédé selon la revendication 5, dans lequel un champ de début (SF) est prévu dans la trame de transmission et le code de contrôle CRC est calculé par le biais des champs champ de début (SF), champ d'arbitrage (AF), champ de commande (CF) et champ de données (DF).

7. Procédé selon la revendication 6, dans lequel la transmission des données est effectuée de manière asynchrone et une resynchronisation est effectuée conformément à une règle de bourrage de bits afin de garantir un mode commun de la station de fin de données et de la station de réception de données, la règle de bourrage de bits étant appliquée pour les zones du champ de début (SF) jusqu'à la fin du champ de données (DF), la règle de bourrage de bits stipulant qu'un bit de bourrage n'est inséré qu'après un nombre défini de bits directement consécutifs ayant le même niveau de bus, le nombre défini étant un nombre naturel supérieur au nombre 5, le nombre des bits de bourrage insérés étant inscrit dans un section du champ de CRC (CRCF).

8. Procédé selon l'une quelconque des revendications précédentes, dans lequel un bit de bourrage est inséré dans des positions prédéfinies de manière fixe dans le champ de CRC (CRCF).

9. Procédé selon la revendication 8, dans lequel le champ de CRC (CRCF) commence par un bit de bourrage prédéfini de manière fixe et les autres bits de bourrage prédéfinis de manière fixe sont insérés des intervalles de 9 bits du champ de CRC (CRCF).

10. Procédé selon l'une quelconque des revendications précédentes, dans lequel l'identifiant dans le champ d'arbitrage (AF) est divisé en sections d'identifiant de « contenu de message » et d'identifiant de « dispositifs ».

11. Procédé selon la revendication 10, dans lequel la section contenant les bits de poids fort est réservée pour la priorisation du contenu de message et la section contenant les bits de poids faible est prévue pour l'identification de dispositifs.

12. Procédé selon la revendication 11, dans lequel l'identifiant présente une longueur de 32 bits et la section contenant les bits de poids fort présente une longueur de 24 bits et la section contenant les bits de poids faible une longueur de 8 bits.

13. Interface de bus conçue pour être utilisée dans le procédé selon l'une quelconque des revendications précédentes.

14. Programme informatique, **caractérisé en ce que** le programme d'ordinateur est conçu pour exécuter, lors de son exécution dans une unité de calcul, les étapes côté émission et/ou les étapes côté réception du procédé de transmission de données selon l'une quelconque des revendications 1 à 12.
